Europäisches Patentamt

European Patent Office

Office européen des brevets

(19)

(11) **EP 1 292 839 B1**

(12) **FASCICULE DE BREVET EUROPEEN**

(45) Date de publication et mention
de la délivrance du brevet:
**06.05.2004 Bulletin 2004/19**

(51) Int Cl.⁷: **G01R 31/3183**, G06F 17/50

(21) Numéro de dépôt: **01943583.3**

(22) Date de dépôt: **07.06.2001**

(86) Numéro de dépôt international:
**PCT/FR2001/001764**

(87) Numéro de publication internationale:
**WO 2001/094960 (13.12.2001 Gazette 2001/50)**

(54) **OUTIL AUTOMATIQUE D'ANALYSE DE TESTABILITE**

AUTOMATISCHES GERÄT FÜR TESTBARKEITSANALYSE

TOOL FOR AUTOMATIC TESTABILITY ANALYSIS

(84) Etats contractants désignés:
**AT BE CH CY DE DK ES FI FR GB GR IE IT LI LU
MC NL PT SE TR**

(30) Priorité: **08.06.2000 FR 0007354**

(43) Date de publication de la demande:
**19.03.2003 Bulletin 2003/12**

(73) Titulaire: **BULL S.A.**
**78430 Louveciennes (FR)**

(72) Inventeurs:
• **AKLI, Florence**
**F-78340 Les Clayes sous Bois (FR)**
• **DEBREIL, Alain**
**F-78370 Plaisir (FR)**
• **NIQUET, Christian**
**F-92340 Bourg la Reine (FR)**

(74) Mandataire: **Denis, Hervé**
**BULL S.A.**
**Département de la Propriété Intellectuelle**
**PC: P4/079**
**rue Jean Jaurès - BP 68**
**78340 Les Clayes-sous-Bois (FR)**

(56) Documents cités:
**US-A- 5 572 535**

• **BRYANT R E: "BINARY DECISION DIAGRAMS
AND BEYOND: ENABLING TECHNOLOGIES
FOR FORMAL VERIFICATION" IEEE/ACM
INTERNATIONAL CONFERENCE ON
COMPUTER-AIDED DESIGN,US,LOS
ALAMITOS, IEEE COMP. SOC. PRESS, 5
novembre 1995 (1995-11-05), pages 236-243,
XP000620913 ISBN: 0-8186-7213-7**
• **FUMMI F ET AL: "A complete testing strategy
based on interacting and hierarchical FSMs"
INTEGRATION, THE VLSI
JOURNAL,NL,NORTH-HOLLAND PUBLISHING
COMPANY. AMSTERDAM, vol. 23, no. 1, 1
octobre 1997 (1997-10-01), pages 75-93,
XP004100336 ISSN: 0167-9260**
• **HOJATI R ET AL: "EARLY QUANTIFICATION
AND PARTITIONED TRANSITION RELATIONS"
PROCEEDINGS OF THE INTERNATIONAL
CONFERENCE ON COMPUTER DESIGN. ICCD.
VLSI IN COMPUTERS AND
PROCESSORS,US,LOS ALAMITOS, IEEE COMP.
SOC. PRESS, 7 octobre 1996 (1996-10-07), pages
12-19, XP000729882 ISBN: 0-8186-7554-3**

**Description**

Le domaine d'application de l'invention est celui des outils automatiques d'analyse de testabilité et de génération automatique de tests de circuits logiques complexes.

Dans un processus de fabrication de circuit intégré, une phase de conception, généralement assistée par ordinateur, génère une liste de connectique (netlist en anglais). Une liste de connectique contient les éléments du circuit tels que des transistors et des connecteurs d'entrée sortie ainsi que les liens entre ces éléments tels que des pistes pour véhiculer des signaux d'un élément à un autre.

La liste de connectique permet de générer un masque qui sert à graver le circuit dans un matériau semi-conducteur, de façon à produire des pastilles (wafer en anglais) pour constituer chacune un échantillon physique du circuit.

Avant d'encapsuler une pastille dans un boîtier pour circuit imprimé, il convient de vérifier que cet échantillon physique est sans défauts, c'est à dire que chaque signal généré par cet échantillon est effectivement celui prévu de l'être par la liste de connectique.

De façon à trier les bons échantillons des mauvais, chaque échantillon est testé en appliquant des stimuli d'états électriques à certains signaux de l'échantillon et en observant si les états électriques de signaux résultants sont conformes à ceux prévus en phase de conception du circuit.

Des vecteurs de test, chacun représentant un ensemble de stimuli, sont déterminés au moyen d'un ordinateur qui traite en mémoire la liste de connectique du circuit. Vu la complexité des circuits intégrés actuels, un traitement exhaustif de la liste de connectique au moyen de tables de vérités nécessiterait des tailles mémoire et des temps de calcul incompatibles avec les contraintes de production en termes de délais et de coût.

Il est déjà connu de l'état de la technique d'utiliser des diagrammes de décision binaire pour réduire la taille mémoire et le temps de calcul nécessaires à une analyse logique de circuit, dans des phases de conception. C'est par exemple le cas des brevets US5434794, US5737242 et US5905977 dans le domaine de la vérification et de la preuve formelle.

Il est également connu de l'état de l'art de coder un signal avec plus que deux états possible dans une forme binaire, par exemple dans : "BINARY DECISION DIAGRAMS AND BEYOND: ENABLING TECHNOLOGIES FOR FORMAL VERIFICATION" IEEE/ACM INTERNATIONAL CONFERENCE ON COMPUTER-AIDED DESIGN,US,LOS ALAMITOS, IEEE COMP. SOC. PRESS, 5 novembre 1995 (1995-11-05), pages 236-243, ISBN: 0-8186-7213-7.

Rappelons qu'un diagramme de décision binaire $T_f$, associé à une première fonction booléenne f(a,b,c,...,w) de variables binaires a,b,c,...,w, est accessible au moyen d'une première structure de données informatiques qui permet de représenter en mémoire les valeurs prises par la première fonction f selon les valeurs prises par les variables binaires a,b,c,...,w. Cette première structure de donnée est construite en utilisant les propriétés connues d'une décomposition de Shannon par rapport à une première variable a, à savoir, en utilisant les notations usuelles d'écriture des fonctions logiques:

$$f(a, b, c,..., w)= \bar{a} \cdot f(a = 0, b, c,..., w)+ a \cdot f(a = 1, b, c,..., w)$$

où $f(a = 0, b, c,..., w)$ est une deuxième fonction booléenne invariable selon a car a y est fixé à zéro et où $f(a = 1, b, c,..., w)$ est une troisième fonction booléenne invariable selon a car a y est fixé à un. La deuxième fonction booléenne prend les mêmes valeurs que la première fonction booléenne selon les valeurs prises par les variables binaires b,c,..., w lorsque a=0. La troisième fonction booléenne prend les mêmes valeurs que la première fonction booléenne selon les valeurs prises par les variables binaires b,c,...,w lorsque a=1. La première structure de données se présente donc comme un triplet d'adresses de zones mémoire {a,f(a=0,b,...),f(a=1,b,...)} qui comprend alors un premier noeud occupé par la première variable a, un pointeur gauche sur une deuxième structure de données {b,f(a=0,b=0,...),f(a=0,b=1,...)} permettant d'accéder à un premier sous-diagramme de décision binaire associé à la deuxième fonction booléenne et un pointeur droit sur une troisième structure de données {b,f(a=1,b=0,...),f(a=1,b=1,...)} permettant d'accéder à un deuxième sous-diagramme de décision binaire associé à la troisième fonction booléenne. La deuxième et la troisième structure de données est de même type que la première structure de donnée avec respectivement un deuxième et un troisième noeud occupé par une deuxième variable binaire b, c. L'opération ci dessus répétée jusqu'à la dernière variable binaire w donne le diagramme de décision binaire $T_f$ constitué par un enchaînement {a,{b,{...},{...}},{b,{...}, {...}}} des structures au moyen des pointeurs. Un identificateur du diagramme de décision binaire $T_f$ pointe sur le premier noeud alors appelé noeud racine.

La représentation en mémoire d'une fonction par un diagramme de décision binaire présente un avantage appréciable de compacité car, si deux ou plusieurs sous-diagrammes de décision binaire sont identiques, une seule représentation en mémoire suffit, deux ou plusieurs pointeurs pouvant pointer sur une même structure de données. Lorsqu'une fonction est indépendante d'une variable binaire, le diagramme de décision binaire se simplifie de lui-même.

La représentation en mémoire d'une fonction par un diagramme de décision binaire peut être implicite dans le sens où il est possible de faire des calculs sur le noeud racine sans développer nécessairement le diagramme de décision binaire pour tous les noeuds.

Une propriété intéressante des diagrammes de décision binaire résulte du constat suivant sur la décomposition de Shannon. Lorsqu'une fonction booléenne h(a,b,c,...,w) résulte d'une opération combinatoire Φ(f,g) d'une ou plusieurs fonctions booléennes f(a,b,c,...,w), g(a,b,c,...,w):

$$h(a,b,c,...,w) = \bar{a} \cdot h(a=0,b,c,...,w) + a \cdot h(a=1,b,c,...,w)$$
$$= \bar{a} \cdot \Phi(f(a=0,b,c,...,w), g(a=0,b,c,...,w)) + a \cdot \Phi(f(a=1,b,c,...,w), g(a=1,b,c,...,w))$$
$$= \Phi(\bar{a} \cdot f(a=0,b,c,...,w), \bar{a} \cdot g(a=0,b,c,...,w)) + \Phi(a \cdot f(a=1,b,c,...,w), a \cdot g(a=1,b,c,...,w))$$
$$= \Phi(\bar{a} \cdot f(a=0,b,c,...,w) + a \cdot f(a=1,b,c,...,w), \bar{a} \cdot g(a=0,b,c,...,w) + a \cdot g(a=1,b,c,...,w))$$

Par exemple, lorsque Φ est un complément logique,

$$h(a,b,c,..., w) = \bar{f}(a,b,c,..., w)$$

$$\bar{f}(a,b,c,...,w) = \overline{\bar{a} \cdot f(a=0,b,c,...,w) + a \cdot f(a=1,b,c,...,w)}$$
$$= \overline{[\bar{a} \cdot f(a=0,b,c,...,w)]} \cdot \overline{[a \cdot f(a=1,b,c,...,w)]}$$
$$= [a + \overline{f(a=0,b,c,...,w)}] \cdot [\bar{a} + \overline{f(a=1,b,c,...,w)}]$$
$$= \bar{a} \cdot \overline{f}(a=0,b,c,...,w) + a \cdot \overline{f}(a=1,b,c,...,w)$$

Le diagramme de décision binaire associé au complément logique d'une fonction f comprend donc le même noeud occupé par la variable a que le diagramme de décision binaire associé à la fonction f où le pointeur sur le sous-diagramme de décision binaire associé à la fonction f pour a égal à zéro est remplacé par un pointeur sur un sous-diagramme de décision binaire associé au complément logique de la fonction f pour a égal à zéro, et où le pointeur sur le sous-diagramme de décision binaire associé à la fonction f pour a égal à un est remplacé par un pointeur sur un sous-diagramme de décision binaire associé au complément logique de la fonction f pour a égal à un. Lorsque Φ est une disjonction logique de deux fonctions f et g,

$$h(a,b,c,..., w) = f(a,b,c,..., w) + g(a,b,c,..., w)$$
$$= \bar{a} \cdot [f(a=0, b,c,..., w) + g(a=0,b,c,..., w)] + a \cdot [f(a=1,b,c,...,w) + g(a=1,b,c,...,w)]$$

Le diagramme de décision binaire associé à la disjonction logique de deux fonctions f et g comprend donc le même noeud occupé par la variable a que le diagramme de décision binaire associé à la fonction f où le pointeur sur le sous-diagramme de décision binaire associé à la fonction f pour a égal à zéro est remplacé par un pointeur sur un sous-diagramme de décision binaire associé à la disjonction logique de la fonction f pour a égal à zéro et de la fonction g pour a égal à zéro, et où le pointeur sur le sous-diagramme de décision binaire associé à la fonction f pour a égal à un est remplacé par un pointeur sur un sous-diagramme de décision binaire associé à la disjonction logique de la fonction f pour a égal à un et de la fonction g pour a égal à un.
Lorsque Φ est une conjonction logique de deux fonctions f et g,

$$h(a,b,c,..., w) = f(a,b,c,...,w) \cdot g(a,b,c,...,w)$$
$$= \bar{a} \cdot [f(a=0,b,c,...,w) \cdot g(a=0,b,c,...,w)] + a \cdot [f(a=1,b,c,...,w) \cdot g(a=1,b,c,...,w)]$$

Le diagramme de décision binaire associé à la conjonction logique de deux fonctions f et g comprend donc le même noeud occupé par la variable a que le diagramme de décision binaire associé à la fonction f où le pointeur sur le sous-diagramme de décision binaire associé à la fonction f pour a égal à zéro est remplacé par un pointeur sur un sous-diagramme de décision binaire associé à la conjonction logique de la fonction f pour a égal à zéro et de la fonction g pour a égal à zéro, et où le pointeur sur le sous-diagramme de décision binaire associé à la fonction f pour a égal à un est remplacé par un pointeur sur un sous-diagramme de décision binaire associé à la conjonction logique de la fonction f pour a égal à un et de la fonction g pour a égal à un.

En procédant par récurrence jusqu'à la dernière variable w d'une ou plusieurs fonctions f, g, il est possible d'effectuer de façon simple toute opération combinatoire $\Phi$ d'un ou de plusieurs diagrammes de décision binaire.

Cependant, le problème est que les diagrammes de décision binaire sont connus pour s'appliquer à des variables ou des propositions logiques purement binaires, c'est-à-dire vrai ou faux. Or, dans le cas de tests de circuit, un signal peut prendre plus de deux états, par exemple un état logique haut ou bas mais aussi un état de haute impédance en sortie de transistor mis à un état bloqué ou encore à un état indéterminé sur un noeud de jonction de plusieurs pistes véhiculant des états de signaux différents. L'invention pallie cet inconvénient.

L'invention a pour objet un procédé pour coder plus de deux états possibles d'un signal, caractérisé en ce qu'il comprend :

- une première étape qui associe au signal une première variable binaire dont une première valeur indique que le signal est à un premier état ou à un deuxième état, une deuxième variable binaire dont une première valeur indique que le signal est au premier état ou à un troisième état, un premier diagramme de décision binaire et un deuxième diagramme de décision binaire ; et
- une deuxième étape qui construit le premier diagramme de décision binaire au moyen d'une première règle faisant conduire le premier diagramme de décision binaire à une première valeur lorsque la première variable binaire est à sa première valeur et qui construit le deuxième diagramme de décision binaire au moyen d'une deuxième règle faisant conduire le deuxième diagramme de décision binaire à la première valeur lorsque la deuxième variable binaire est à sa première valeur.

Ainsi, une conjonction logique du premier et du deuxième diagramme de décision binaire qui conduit à la première valeur, code le premier état du signal. Une conjonction logique du premier et du complément du deuxième diagramme de décision binaire qui conduit à la première valeur, code le deuxième état du signal. Une conjonction logique du complément du premier et du deuxième diagramme de décision binaire qui conduit à la première valeur, code le troisième état du signal.

L'invention a aussi pour objets corollaires un système informatique, tel qu'un ordinateur, un programme informatique et un support d'enregistrement, tel qu'une disquette magnétique ou un cédérom, permettant la mise en oeuvre du procédé de l'invention.

D'autres avantages et détails de l'invention ressortent de la description de l'exemple préférentiel de mise en oeuvre qui suit; faite en référence aux figures suivantes :

- la figure 1 décrit des étapes du procédé conforme à l'invention ;
- la figure 2 représente deux diagrammes de décision binaires élémentaires conformes à l'invention ;
- la figure 3 représente un premier exemple de circuit élémentaire auquel appliquer l'invention ;
- la figure 4 représente un deuxième exemple de circuit élémentaire auquel appliquer l'invention ; et
- la figure 5 représente un diagramme de décision binaire conforme à l'invention pour un signal résultant de l'état d'autres signaux.

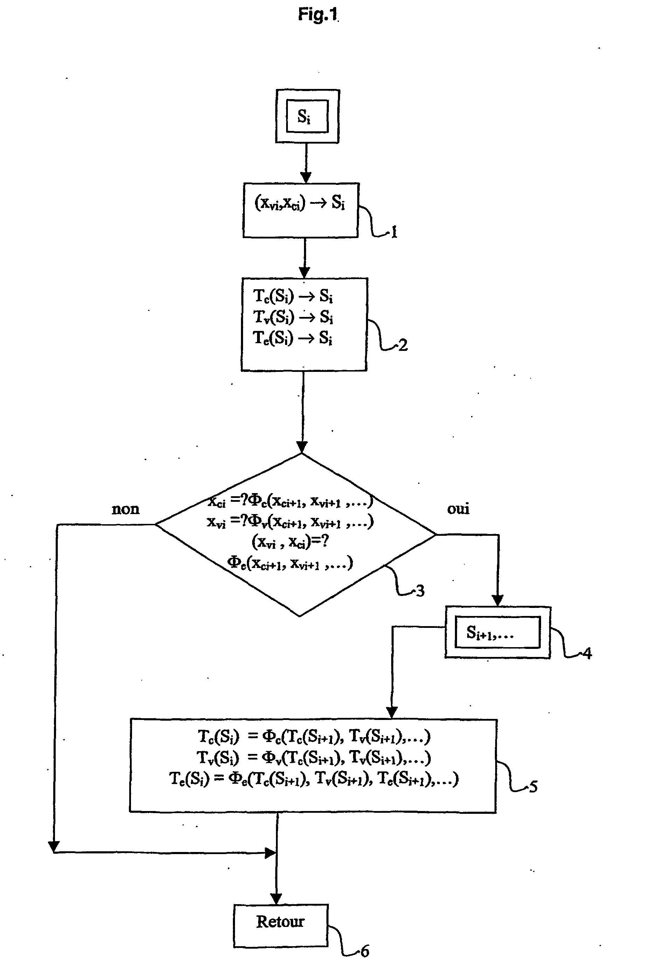

La figure 1 décrit les étapes du procédé appliqué par ordinateur à une liste de connectique d'un circuit analysé dont un signal $s_i$ est extrait.

Dans une première étape 1, un couple de variables binaires $(x_{vi}, x_{ci})$ est attribué au signal $s_i$ pour coder trois états déterminés possibles du signal $s_i$. La variable $x_{ci}$, dite de contexte est définie pour indiquer que, lorsque sa valeur est égale à 1, les valeurs 0 et 1 de la variable $x_{vi}$ codent respectivement directement des états logiques B et H du signal $s_i$. Lorsque la valeur de la variable de contexte $x_{ci}$ est égale à 0, les valeurs 0 et 1 de la variable $x_{vi}$ codent respectivement un état indéterminé et un état Z du signal $s_i$. L'état Z du signal $s_i$ est celui de haute impédance au sens où on l'entend habituellement dans un circuit électrique. Dans l'état indéterminé, on retrouve un état E d'erreur du signal $s_i$ telle que par exemple un court circuit électrique. Le couple de variables binaires $(x_{vi}, x_{ci})$ permet ainsi de coder quatre états possibles du signal $s_i$.

Dans une deuxième étape 2, trois diagrammes de décision binaire $T_v(s_i)$, $T_c(s_i)$, $T_e(s_i)$, sont attribués au signal $s_i$.

Le diagramme de décision binaire $T_v(s_i)$, dit de valeur, est construit de façon à ce qu'il conduise à 1 si l'état du signal $s_i$ est l'état de haute impédance Z ou l'état logique H.

Le diagramme de décision binaire $T_c(s_i)$, dit de contexte, est construit de façon à ce qu'il conduise à 1 si l'état du signal si est l'état logique B ou l'état logique H.

Le diagramme de décision binaire $T_e(s_i)$, dit d'erreur, est construit de façon à ce qu'il conduise à 1 si l'état du signal $s_i$ est un état d'erreur.

Dans une étape 3, l'ordinateur recherche dans la liste de connectique s'il existe un élément générant le signal $s_i$ à partir d'un ou plusieurs signaux $s_{i+1}$, $s_{i+2}$.

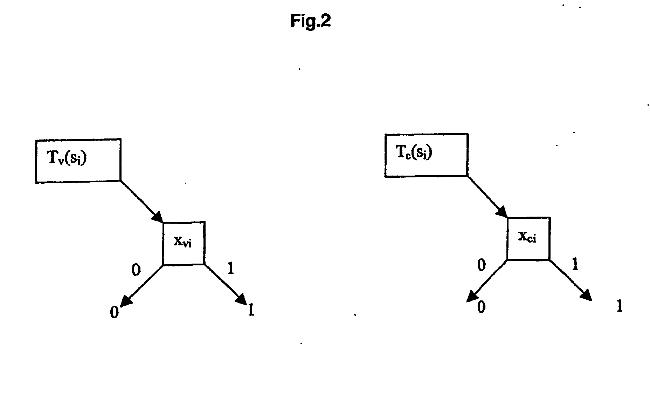

Lorsque le signal $s_i$ ne dépend d'aucun autre signal, chacune des variables $x_{vi}$,$x_{ci}$ du couple de variables binaires ($x_{vi}$,$x_{ci}$) peut prendre une valeur égale à 0 ou à 1. C'est par exemple le cas pour un signal d'entrée du circuit électrique ou pour un signal intermédiaire qu'il est possible de forcer au moyen d'une pointe de test. Les diagrammes de décision binaire $T_v(s_i)$, $T_c(s_i)$ sont représentés en figure 2 où $T_v(s_i)$ conduit à 1 si $x_{vi}$ est égal à 1, $T_c(s_i)$ conduit à 1 si $x_{ci}$ est égal à 1. $T_e(s_i)$ n'a pas de raison d'être car il serait préjudiciable d'appliquer une erreur sur une entrée d'un circuit à tester. Le procédé passe alors directement de l'étape 3 à une étape 6 de retour qui met les diagrammes de décision binaire à disposition en mémoire de l'ordinateur.

Lorsque le signal $s_i$ dépend d'au moins un signal $s_{i+1}$, $s_{i+2}$, l'ordinateur recherche, dans une bibliothèque de règles, une ou plusieurs règles donnant un comportement du signal $s_i$ en fonction du ou des signaux $s_{i+1}$, $s_{i+2}$ pour l'élément de la liste de connectique générant le signal $s_i$.

Dans une étape 4, les diagrammes de décision binaire $T_v(s_{i+1})$, $T_c(s_{i+1})$, $T_e(s_{i+1})$ pour chaque signal $s_{i+1}$ sont recherchés en mémoire de l'ordinateur. Si ces diagrammes de décision binaire n'existent pas déjà, les étapes 1 à 6 sont exécutées récursivement pour chacun des signaux $s_{i+1}$.

Dans une étape 5, par application des règles trouvées en étape 3 :

- le diagramme de décision binaire $T_v(s_i)$ est construit au moyen d'une combinaison $\Phi_v$ qui donne $T_v(s_i)$ en fonction des diagrammes de décision binaire $T_v(s_{i+1})$, $T_c(s_{i+1})$, $T_e(s_{i+1})$, $T_v(s_{i+2})$, $T_c(s_{i+2})$, $T_e(s_{i+2})$;
- le diagramme de décision binaire $T_c(s_i)$ est construit au moyen d'une combinaison $\Phi_c$ qui donne $T_v(s_i)$ en fonction des diagrammes de décision binaire $T_v(s_{i+1})$, $T_c(s_{i+1})$, $T_e(s_{i+1})$, $T_v(s_{i+2})$, $T_c(s_{i+2})$, $T_e(s_{i+2})$;
- le diagramme de décision binaire $T_e(s_i)$ est construit au moyen d'une combinaison $\Phi_e$ qui donne $T_v(s_i)$ en fonction des diagrammes de décision binaire $T_v(s_{i+1})$, $T_c(s_{i+1})$, $T_e(s_{i+1})$, $T_v(s_{i+2})$, $T_c(s_{i+2})$, $T_e(s_{i+2})$.

Les préceptes connus de combinaison de diagrammes de décision binaire sont appliqués.

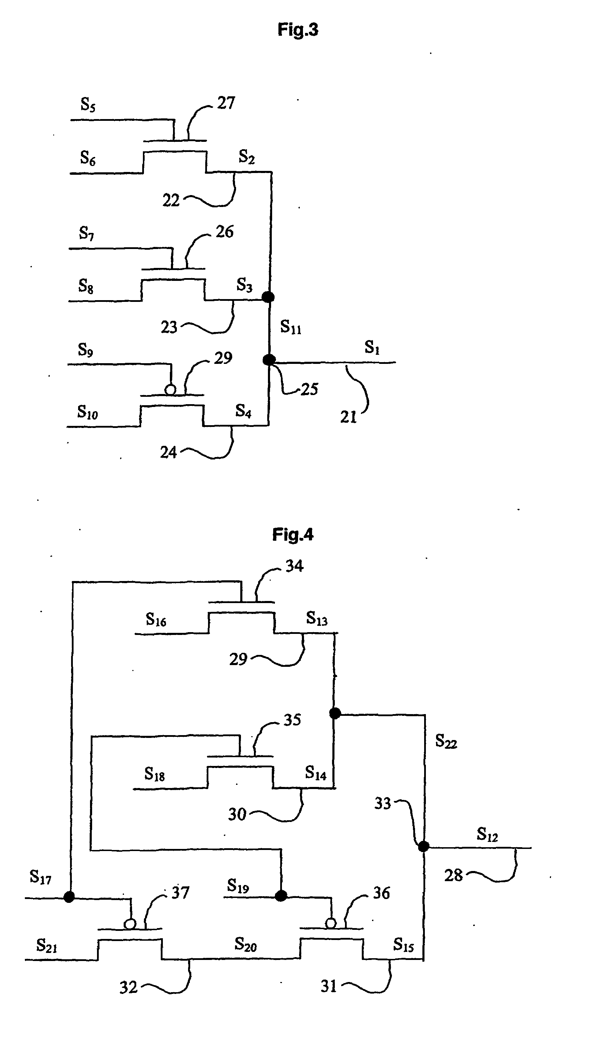

Appliquons par exemple le procédé précédemment décrit au circuit élémentaire de la figure 3, qui constitue un multiplexeur à trois entrées.

Un conducteur 21 véhicule un signal $s_1$. Le conducteur 21 est raccordé, en un point 25, à trois conducteurs 22, 23, 24 en parallèle. Les conducteurs 22, 23, 24 véhiculent chacun respectivement un signal $s_2$, $s_3$, $s_4$. Le raccordement des signaux $s_2$, $s_3$ au point 25 est équivalent à un signal intermédiaire $s_{11}$ raccordé au point 25 avec le signal $s_4$.

La variable xv1 est égale à 1 si et seulement si l'état de chacun des signaux $s_1$, $s_2$, $s_3$ est l'état de haute impédance Z ou l'état logique H.

La règle Rv applicable pour construire le diagramme de décision binaire $T_v(s_{11})$ est une règle Rvr pour deux conducteurs raccordés en un même point 25 :

$$T_v(s_{11}) = T_v(s_2) \cdot T_v(s_3).$$

$T_v(s_{11})$ étant maintenant présent en mémoire, la règle Rvr est appliquée à nouveau à $s_{11}$ et $s_4$.

$$T_v(s_1) = T_v(s_{11}) \cdot T_v(s_4).$$

Une erreur se produit sur le signal $s_{11}$ si l'un des signaux $s_2$, $s_3$, est à l'état logique H alors que l'autre signal $s_3$, $s_2$ est à l'état logique B, ou si l'un des signaux $s_2$, $s_3$, est à l'état d'erreur. La règle Re applicable pour construire le diagramme de décision binaire $T_e(s_{11})$ est une règle Rer pour deux conducteurs raccordés au point 25 :

$$Te(s11) = Tc(s2) \cdot Tc(s3) \cdot \left[ Tv(s2) \cdot \overline{Tv(s3)} + \overline{Tv(s2)} \cdot Tv(s3) \right] + Te(s2) + Te(s3)$$

Une erreur se produit sur le signal $s_1$ si l'un des signaux $s_{11}$, $s_4$, est à l'état logique H alors que l'autre signal $s_4$, $s_{11}$ est à l'état logique B, ou si l'un des signaux $s_{11}$, $s_4$, est à l'état d'erreur. La règle Rer est à nouveau applicable pour construire le diagramme de décision binaire $T_e(s_1)$

$$Te(s1) = Tc(s11) \cdot Tc(s4) \cdot \left[Tv(s11) \cdot \overline{Tv(s4)} + \overline{Tv(s11)} \cdot Tv(s4)\right] + Te(s11) + Te(s4)$$

La variable xc1 est égale à 1 si l'état du signal $s_1$ est l'état B ou l'état H logique. Le signal $s_{11}$ est à l'état B ou H si et seulement si le signal $s_2$ ou le signal $s_3$ est à l'état B ou H logique et si aucune erreur ne résulte des signaux $s_2$ et $s_3$ sur le signal $s_{11}$. La règle Rc applicable pour construire le diagramme de décision binaire $T_c(s_{11})$ est une règle Rcr pour deux conducteurs raccordés au point 25 :

$$Tc(s11) = \left[Tc(s2) + Tc(s3)\right] \cdot \overline{\left[\overline{Tc(s2) \cdot Tc(s3)} \cdot \left[Tv(s2) \cdot \overline{Tv(s3)} + \overline{Tv(s2)} \cdot Tv(s3)\right]\right]}$$

$$Tc(s11) = \left[Tc(s2) + Tc(s3)\right] \cdot \left[\overline{Tc(s2)} + \overline{Tc(s3)} + \left[\overline{Tv(s2)} + Tv(s3)\right]\left[Tv(s2) + \overline{Tv(s3)}\right]\right]$$

$$Tc(s11) =$$
$$+ Tc(s2) \cdot \left[\overline{Tc(s3)} + \overline{Tv(s2)} \cdot \overline{Tv(s3)} + Tv(s2) \cdot Tv(s3)\right]$$
$$+ Tc(s3) \cdot \left[\overline{Tc(s2)} + \overline{Tv(s2)} \cdot \overline{Tv(s3)} + Tv(s2) \cdot Tv(s3)\right]$$

La règle Rcr est appliquée à nouveau pour les signaux $s_{11}$ et $s_4$:

$$Tc(s1) =$$
$$+ Tc(s11) \cdot \left[\overline{Tc(s4)} + \overline{Tv(s11)} \cdot \overline{Tv(s4)} + Tv(s11) \cdot Tv(s4)\right]$$
$$+ Tc(s4) \cdot \left[\overline{Tc(s11)} + \overline{Tv(s11)} \cdot \overline{Tv(s4)} + Tv(s11) \cdot Tv(s4)\right]$$

Si, pour $s_2$, $T_v(s_2)$, $T_c(s_2)$, $T_e(s_2)$ ne sont pas présents en mémoire, la deuxième étape est répétée pour le signai $s_2$.

Le conducteur 22 est raccordé au drain d'un transistor 27 MOS de type N. La grille du transistor 27 reçoit un signal $s_5$ et la source du transistor 27 reçoit un signal $s_6$. En technologie CMOS, la notion de drain et de source d'un transistor est liée de façon connue à son régime de fonctionnement, aussi ces deux notions sont-elles interchangeables.

Le signal $s_2$ est à l'état H logique si et seulement si les signaux $s_5$ et $s_6$ sont à l'état H logique. Le signal $s_2$ est à l'état Z de haute impédance si et seulement si le signal $s_5$ est à l'état B logique ou si le signal $s_5$ est à l'état logique H et le signal $s_6$ est à l'état Z de haute impédance. La règle Rv qui s'applique est une règle Rvn :

$$Tv(s2) = \left[Tc(s5) \cdot Tv(s5) \cdot Tc(s6) \cdot Tv(s6) + Tc(s5) \cdot \overline{Tv(s5)}\right] + Tc(s5) \cdot Tv(s5) \cdot \overline{Tc(s6)} \cdot Tv(s6)$$

ce qui par simplification donne :

$$Tv(s2) = \left[Tc(s5) \cdot Tv(s5) \cdot Tv(s6) + Tc(s5) \cdot \overline{Tv(s5)}\right]$$

Le signal $s_2$ est à l'état E d'erreur si le signal $s_5$ est à l'état Z de haute impédance. En effet, une grille de transistor attaquée par un signal de haute impédance est particulièrement sensible au bruit. La règle Re qui s'applique est une règle Ren :

$$Te(s2) = Tv(s5) \cdot \overline{Tc(s5)}$$

Le signal $s_2$ est à l'état B ou H logique si et seulement si le signal $s_5$ est à l'état H logique et le signal $s_6$ est à l'état B ou H logique. La règle Rc qui s'applique est une règle Rcn :

$$Tc(s2) = Tc(s5) \cdot Tv(s5) \cdot Tc(s6)$$

Si, pour $s_4$, $T_v(s_4)$, $T_c(s_4)$, $T_e(s_4)$ ne sont pas présents en mémoire, la deuxième étape est répétée pour le signal $s_4$.

Le conducteur 23 est raccordé au drain d'un transistor 26 MOS de type N. La grille du transistor 26 reçoit un signal $s_7$ et la source du transistor 26 reçoit un signal $s_8$.

Les deux premières étapes sont exécutées pour le signal $s_3$ au moyen des mêmes règles Rvn, Rcn et Ren que pour le signal $s_2$ de façon à obtenir :

$$Tv(s3) = \left[ Tc(s7) \cdot Tv(s7) \cdot Tv(s8) + Tc(s7) \cdot \overline{Tv(s7)} \right]$$

$$Te(s3) = Tv(s7) \cdot \overline{Tc(s7)}$$

$$Tc(s3) = Tc(s7) \cdot Tv(s7) \cdot Tc(s8)$$

Le conducteur 24 est raccordé au drain d'un transistor 29 MOS de type P. La grille du transistor 29 reçoit un signal $s_9$ et la source du transistor 27 reçoit un signal $s_{10}$.

Le signal $s_4$ est à l'état H logique si et seulement si les signaux $s_9$ et $s_{10}$ sont respectivement à l'état B et H logique. Le signal $s_4$ est à l'état Z de haute impédance si et seulement si le signal $s_9$ est à l'état H logique ou si le signal $s_9$ est à l'état B logique et le signal $s_{10}$ est à l'état Z de haute impédance. Après simplification, la règle Rv qui s'applique est une règle Rvp :

$$Tv(s4) = \left[ Tc(s9) \cdot \overline{Tv(s9)} \cdot Tv(s10) + Tc(s9) \cdot Tv(s9) \right]$$

Le signal $s_4$ est à l'état E d'erreur si le signal $s_9$ est à l'état Z de haute impédance. En effet, une grille de transistor attaquée par un signal de haute impédance est particulièrement sensible au bruit. La règle Re qui s'applique est une règle Rep :

$$Te(s4) = Tv(s9) \cdot \overline{Tc(s9)}$$

Le signal $s_4$ est à l'état B ou H logique si et seulement si le signal $s_9$ est à l'état B logique et le signal $s_{10}$ est à l'état B ou H logique. La règle Rc qui s'applique est une règle Rcp :

$$Tc(s4) = Tc(s9) \cdot \overline{Tv(s9)} \cdot Tc(s10)$$

On obtient ainsi les diagrammes de décision binaire $T_v(s_1)$, $T_c(s_1)$, $T_e(s_1)$ en fonction des diagrammes de décision binaire $T_v(s_5)$, $T_c(s_5)$, $T_v(s_6)$, $T_c(s_6)$, $T_v(s_7)$, $T_c(s_7)$, $T_v(s_8)$, $T_c(s_8)$, $T_v(s_9)$, $T_c(s_9)$, $T_v(s_{10})$, $T_c(s_{10})$.

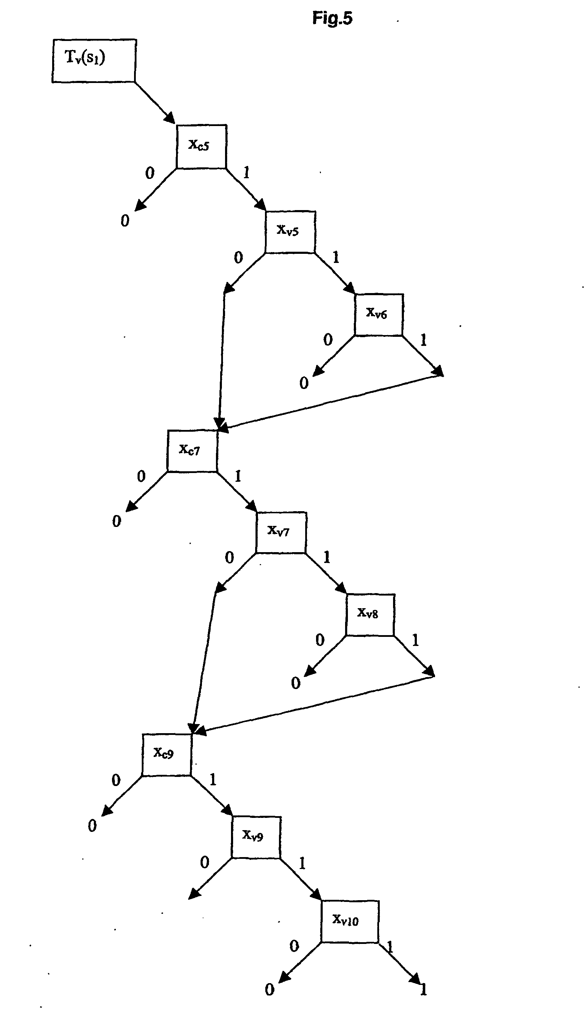

La figure 5 montre par exemple le diagramme de décision binaire $T_v(s_1)$ obtenu en remplaçant successivement chacun des diagrammes de décision binaire dans les formules données ci-dessus pour $T_v(s_1)$ par les diagrammes de décision binaire $T_v(s_i)$, $T_c(s_i)$, pour s égal à $s_5$, $s_6$, $s_7$, $s_8$, $s_9$, $s_{10}$.

Si on s'intéresse aux états possibles du signal $s_1$, pour deux états logiques B et H possibles de chacun des signaux $s_5$ à $s_{10}$, la troisième étape est exécutée où chacun des diagrammes de décision binaire $T_c(s_5)$, $T_c(s_6)$, $T_c(s_7)$, $T_c(s_8)$, $T_c(s_9)$, $T_c(s_{10})$ vaut 1 et où chacun des diagrammes de décision binaire $T_v(s_5)$, $T_v(s_6)$, $T_v(s_7)$, $T_v(s_8)$,

$T_v( s_9)$, $T_v( s_{10})$, est remplacé par respectivement par chacun des diagrammes de décision binaire $\{x_{v5};0;1\}$, $\{x_{v6};0;1\}$, $\{x_{v7};0;1\}$, $\{x_{v8};0;1\}$, $\{x_{v9};0;1\}$, $\{x_{v10};0;1\}$. On obtient ainsi trois diagrammes de décision binaire $T_v( s_1)$, $T_c( s_1)$, $T_e( s_1)$ avec des noeuds occupés par les variables $x_{v5}$, $x_{v6}$, $x_{v7}$, $x_{v8}$, $x_{v9}$, $x_{v10}$ et des feuilles à 0 ou à 1.

Pour connaître par exemple les valeurs de $x_{v5}$, $x_{v6}$, $x_{v7}$, $x_{v8}$, $x_{v9}$, $x_{v10}$ qui mettent le signal $s_1$ à l'état logique 1, la quatrième étape construit un diagramme de décision binaire $T_1( s_1)$ au moyen de la règle R1 :

$$T1(s1)=Tv(s1)\cdot Tc(s1)\cdot \overline{Te(s1)}$$

Le diagramme de décision binaire $T_1( s_1)$ est parcouru sur chaque branche conduisant du noeud occupé par la variable $x_{v5}$, à une feuille occupée par la valeur 1, en conservant dans une conjonction logique chaque variable $x_{v5}$, $x_{v6}$, $x_{v7}$, $x_{v8}$, $x_{v9}$, $x_{v10}$ rencontrée telle quelle si le parcours de la branche est poursuivi au moyen du pointeur droit et complémentée si le parcours de la branche est poursuivi au moyen du pointeur gauche. Chaque conjonction logique obtenue par le parcours sur une branche, est conservée dans une disjonction logique jusqu'à avoir parcouru toutes les branches conduisant à une feuille occupée par la valeur 1. On obtient ainsi l'équation logique du circuit de la figure 3 :

$$s1 =$$

$$+s5\cdot s6\cdot s7\cdot s8\cdot \overline{s9}\cdot s10+s5\cdot s6\cdot s7\cdot s8\cdot s9+s5\cdot s6\cdot \overline{s7}\cdot \overline{s9}\cdot s10$$

$$+\overline{s5}\cdot s7\cdot s8\cdot s9+\overline{s5}\cdot s7\cdot s8\cdot \overline{s9}\cdot s10+\overline{s5}\cdot \overline{s7}\cdot \overline{s9}\cdot s10+s5.s6.s7.\overline{s9}$$

Appliquons par exemple le procédé précédemment décrit au circuit élémentaire de la figure 4 où cinq signaux d'entrée $s_{16}$, $s_{17}$, $s_{18}$, $s_{19}$, $s_{21}$ se combinent pour générer un signal $s_{12}$.

L'entité élémentaire de circuit de la figure 4 comprend deux transistors NMOS 34 et 35, dont les sources sont respectivement attaquées par les signaux $s_{16}$ et $s_{18}$, dont les grilles sont respectivement attaquées par les signaux $s_{17}$ et $s_{19}$, et dont les drains génèrent respectivement des signaux $s_{13}$ et $s_{14}$ sur des conducteurs 29 et 30. L'entité élémentaire de circuit de la figure 4 comprend aussi deux transistors PMOS 37 et 36, dont les sources sont respectivement attaquées par le signal $s_{21}$ et un signal $s_{20}$, dont les grilles sont respectivement attaquées par les signaux $s_{17}$ et $s_{19}$, et dont les drains génèrent respectivement le signal $s_{20}$ et un signal $s_{15}$ sur des conducteurs 32 et 31. Les conducteurs 29, 30 et 31 sont raccordés à un conducteur 28 en un point 33.

La cinquième étape scrute (*scan* en anglais) chacun des signaux $s_{16}$, $s_{17}$, $s_{18}$, $s_{19}$, $s_{21}$, de la liste de connectique et pour chaque signal scruté, exécute les deux premières étapes.

Dans le cas où les sources des transistors 34 et 35 sont reliées à la masse, les diagrammes de décision binaire $T_v( s_{16})$, $T_c( s_{16})$, $T_e( s_{16})$, $T_v( s_{18})$, $T_c( s_{18})$, $T_e( s_{18})$ sont respectivement égaux aux singletons $\{0\}$, $\{1\}$, $\{0\}$, $\{0\}$, $\{1\}$, $\{0\}$. Dans le cas où la source du transistor 37 est reliée à l'alimentation, les diagrammes de décision binaire $T_v( s_{21})$, $T_c( s_{21})$, $T_e( s_{21})$, sont respectivement égaux aux singletons $\{1\}$, $\{1\}$, $\{0\}$. Dans le cas où les grilles des transistors 34 et 37 sont reliés à une entrée nécessairement mises à un état logique B ou H, les diagrammes de décision binaire $T_v( s_{17})$, $T_c( s_{17})$, $T_e( s_{17})$, sont respectivement $\{x_{17},0,1\}$, $\{1\}$, $\{0\}$. Dans le cas où les grilles des transistors 35 et 36 sont reliés à une entrée nécessairement mises à un état logique B ou H, les diagrammes de décision binaire $T_v( s_{19})$, $T_c( s_{19})$, $T_e( s_{19})$, sont respectivement $\{x_{v19},0,1\}$, $\{1\}$, $\{0\}$.

La sixième étape scrute ensuite les éléments du circuit élémentaire attaqués par les signaux $s_{16}$, $s_{17}$, $s_{18}$, $s_{19}$, $s_{21}$, de la liste de connectique et associe aux transistors 34, 35, 37, respectivement les signaux $s_{13}$, $s_{14}$, $s_{20}$, pour chacun desquels elle exécute les deux premières étapes.

Pour le transistor 34, les règles Rvn, Rcn, Ren s'appliquent au signal $s_{13}$, dans la deuxième étape.

$$Tv(s13) = \left[Tc(s17)\cdot Tv(s17)\cdot Tv(s16) + Tc(s17)\cdot \overline{Tv(s17)}\right]$$

$$Tc(s13) = Tc(s17) \cdot Tv(s17) \cdot Tc(s16)$$

$$Te(s13) = Tv(s17) \cdot \overline{Tc(s17)}$$

Ce qui donne, en appliquant les règles de combinaison connues de diagrammes de décision binaire :

$$T_v( s_{13}) = \{x_{v17},1,0\}$$

$$T_c( s_{13}) = \{x_{v17},0,1\}$$

$$T_e( s_{13}) = \{0\}$$

Pour le transistor 35, les règles Rvn, Rcn, Ren s'appliquent au signal $s_{14}$, dans la deuxième étape pour donner de façon identique :

$$T_v( s_{14}) = \{x_{v19},1,0\}$$

$$T_c( s_{14}) = \{x_{v19},0,1\}$$

$$T_e( s_{14}) = \{0\}$$

Pour le transistor 37, les règles Rvp, Rcp, Rep s'appliquent au signal $s_{20}$, dans la deuxième étape.

$$Tv(s20) = \left[\overline{Tc(s17) \cdot \overline{Tv(s17)}} \cdot Tv(s21) + Tc(s17) \cdot Tv(s17)\right]$$

$$Tc(s20) = Tc(s17) \cdot \overline{Tv(s17)} \cdot Tc(s21)$$

$$Te(s20) = Tv(s17) \cdot \overline{Tc(s17)}$$

Ce qui donne, en appliquant les règles de combinaison connues de diagrammes de décision binaire :

$$T_v( s_{20}) = \{1\}$$

$$T_c( s_{20}) = \{x_{v17},1,0\}$$

$$T_e( s_{20}) = \{0\}$$

La sixième étape est relancée pour scruter les éléments du circuit élémentaire attaqués par les signaux précédemment générés $s_{13}$, $s_{14}$, $s_{20}$, de la liste de connectique et associe à ces éléments qui sont le point 33 et le transistor 36, respectivement les signaux $s_{22}$, $s_{15}$, pour chacun desquels elle exécute les deux premières étapes.

Pour le point 33, les règles Rvr, Rcr, Rer s'appliquent au signal $s_{22}$, dans la deuxième étape.

$$Tv(s_{22}) = Tv(s_{13}) \cdot Tv(s_{14})$$

$$Tc(s22) = \\ + Tc(s13) \cdot \left[\overline{Tc(s14) + \overline{Tv(s13)} \cdot \overline{Tv(s14)}} + Tv(s13) \cdot Tv(s14)\right] \\ + Tc(s14) \cdot \left[\overline{Tc(s13) + \overline{Tv(s13)} \cdot \overline{Tv(s14)}} + Tv(s13) \cdot Tv(s14)\right]$$

$$Te(s22) = Tc(s13) \cdot Tc(s14) \cdot \left[\overline{Tv(s13) \cdot \overline{Tv(s14)}} + \overline{Tv(s13)} \cdot Tv(s14)\right]$$

Ce qui donne, en appliquant les règles de combinaison connues de diagrammes de décision binaire:

$$T_v(s_{22}) = \{x_{v17}, \{x_{v19}, 1, 0\}, 0\}$$

$$T_c(s_{22}) = \{x_{v17}, \{x_{v19}, 0, 1\}, 1\}$$

$$T_e(s_{22}) = \{x_{v17}, 0, \{x_{v19}, 0, 0\}\} = \{0\}$$

Pour le transistor 36, les règles Rvp, Rcp, Rep s'appliquent au signal $s_{15}$, dans la deuxième étape.

$$Tv(s15) = \left[\overline{Tc(s19) \cdot \overline{Tv(s19)}} \cdot Tv(s20) + Tc(s19) \cdot Tv(s19)\right]$$

$$Tc(s15) = Tc(s19) \cdot \overline{Tv(s19)} \cdot Tc(s20)$$

$$Te(s15) = Tv(s19) \cdot \overline{Tc(s19)}$$

Ce qui donne, en appliquant les règles de combinaison connues de diagrammes de décision binaire :

$$T_v(s_{15}) = \{1\}$$

$$T_c(s_{15}) = \{xv_{17}, \{x_{v19}, 1, 0\}, 0\}$$

$$T_e(s_{15}) = \{0\}$$

La sixième étape est relancée pour scruter les éléments du circuit élémentaire attaqués par les signaux précédemment générés $s_{22}$, $s_{15}$, de la liste de connectique et associe au seul élément trouvé qui est le point 33, le signal $s_{12}$ pour lequel elle exécute les deux premières étapes.

Pour le point 33, les règles Rvr, Rcr, Rer s'appliquent au signal $s_{12}$, dans la deuxième étape.

$$Tv(s_{12}) = Tv(s_{22}) \cdot Tv(s_{15})$$

$$\begin{aligned}Tc(s12) = \\ + Tc(s22) \cdot \left[\overline{Tc(s15)} + \overline{Tv(s22)} \cdot \overline{Tv(s15)} + Tv(s22) \cdot Tv(s15)\right] \\ + Tc(s15) \cdot \left[\overline{Tc(s22)} + \overline{Tv(s22)} \cdot \overline{Tv(s15)} + Tv(s22) \cdot Tv(s15)\right]\end{aligned}$$

$$Te(s12) = Tc(s22) \cdot Tc(s15) \cdot \left[\overline{Tv(s22) \cdot \overline{Tv(s15)}} + \overline{Tv(s22)} \cdot Tv(s15)\right]$$

Ce qui donne, en appliquant les règles de combinaison connues de diagrammes de décision binaire :

$$T_v( s_{12}) = \{x_{v17},\{ x_{v19},1,0\},0\}$$

$$T_c( s_{12}) = \{x_{v17},1,\{ x_{v19},1,1\}\}=\{1\}$$

$$T_e( s_{12}) = \{ x_{v17},0,\{ x_{v19},0,0\}\}=\{0\}$$

Le seul signal restant étant le signal $s_{12}$, la quatrième étape donne le diagramme de décision binaire $T_{log}$ ( $s_{12}$) au moyen de la règle Rlog :

$$T_{log}( s_{12}) = T_v( s_{12})\cdot T_c( s_{12})$$

$$= \{x_{v17},\{ x_{v19},1,0\},0\}$$

La variable binaire $x_{v12}$ est à la valeur logique 1 pour les branches du diagramme de décision binaire $T_{log}$ ( $s_{12}$) qui mènent à 1. Ce qui s'écrit :

$$xv12 = \overline{xv17} \cdot \overline{xv19}$$

Dans la quatrième étape, le circuit de la figure 4 est reconnu comme étant une porte NOR.

Dans l'exemple de mise en oeuvre de l'invention, un premier diagramme de décision binaire conduit à 1 lorsque l'état du signal auquel il est associé est un état de haute impédance Z ou un état logique H, un deuxième diagramme de décision binaire conduit à 1 lorsque l'état du signal auquel il est associé est un état logique B ou un état logique H, un troisième diagramme de décision binaire conduit à 1 lorsque l'état du signal auquel il est associé est un état d'erreur E.

L'homme du métier peut aisément tirer partie de l'enseignement de l'invention en définissant autrement les trois diagrammes de décision binaire, par exemple le premier diagramme de décision binaire conduit à 1 lorsque l'état du signal auquel il est associé est un état de haute impédance Z ou un état logique H, le deuxième diagramme de décision binaire conduit à 1 lorsque l'état du signal auquel il est associé est un état de haute impédance Z ou un état logique B, le troisième diagramme de décision binaire conduit à 1 lorsque l'état du signal auquel il est associé est un état d'erreur E. Selon les besoins qu'il estime les plus appropriés à une application particulière, l'homme du métier peut définir d'autres diagrammes de décision binaire pour coder chacun positivement une présence de un ou deux états possibles parmi plusieurs, négativement une absence de ce ou ces deux états possibles.

Le choix du mode de mise en oeuvre de la description qui précède présente un avantage intéressant pour reconnaître rapidement un état logique d'un signal a priori binaire. En effet, lorsque le deuxième diagramme de décision binaire $T_c( s_i)$ conduit à 1, l'état du signal est l'un des états logiques B ou H, et donc ni l'état Z, ni l'état E. Comme le premier diagramme de décision binaire $T_v( s_i)$ conduit à 1 si l'état du signal est l'état Z ou l'état H, le premier diagramme de décision binaire $T_v( s_i)$ conduit alors à 1 si l'état du signal est l'état H. Comme le premier diagramme de décision binaire $T_v( s_i)$ conduit à 0 si l'état du signal n'est pas l'état H, le premier diagramme de décision binaire $T_v( s_i)$ conduit alors à 0 si l'état du signal est l'état B. On remarque ainsi que lorsque le diagramme de décision binaire $T_c( s_i)$, dit de contexte conduit à 1, le fait de conduire à 1 pour le diagramme de décision binaire $T_v( s_i)$, dit de valeur, indique un état logique H du signal $s_i$, le fait de conduire à 0, indique un état logique B du signal $s_i$.

**Revendications**

1. Procédé pour coder plus de deux états possibles (H,B,Z) d'un premier signal ($s_i$), **caractérisé en ce qu'**il comprend :

   - une première étape qui associe au premier signal ($s_i$), une première variable binaire ($x_{ci}$) dont une première valeur (1) indique que le premier signal ($s_i$) est à un premier état (H) ou à un deuxième état (B), une deuxième variable binaire ($x_{vi}$) dont une première valeur (1) indique que le premier signal ($s_i$) est au premier état (H) ou à un troisième état (Z), un premier diagramme de décision binaire ($T_c(s_i)$) et un deuxième diagramme de décision binaire ($T_v(s_i)$) ; et

- une deuxième étape qui construit le premier diagramme de décision binaire ($T_c(s_i)$) au moyen d'une première règle (Rc) faisant conduire le premier diagramme de décision binaire ($T_c(s_i)$) à une première valeur (1) lorsque la première variable binaire ($x_{ci}$) est à sa première valeur (1) et qui construit le deuxième diagramme de décision binaire ($T_v(s_i)$) au moyen d'une deuxième règle (Rv) faisant conduire le deuxième diagramme de décision binaire ($T_v(s_i)$) à la première valeur (1) lorsque la deuxième variable binaire ($x_{vi}$) est à sa première valeur (1).

2. Procédé selon la revendication 1, **caractérisé en ce que**, le premier signal ($s_i$) étant généré par une entité élémentaire recevant en entrée un ou plusieurs deuxièmes signaux ($s_{i+1}$, $s_{i+2}$) auxquels sont appliqués la première et la deuxième étape, une première opération combinatoire ($\Phi_c$) et une deuxième opération combinatoire ($\Phi_v$) sont associées à cette entité, la première opération combinatoire ($\Phi_c$) donnant la valeur de la première variable binaire ($x_{ci}$) associée au premier signal ($s_i$), en fonction de la valeur de chacune de la ou des premières variables binaires ($x_{ci+1}$, $x_{ci+2}$) associées respectivement au ou aux deuxièmes signaux ($s_{i+1}$, $s_{i+2}$) et en fonction de la valeur de chacune de la ou des deuxièmes variables binaires ($x_{vi+1}$, $x_{vi+2}$) associées respectivement au ou aux deuxièmes signaux ($s_{i+1}$, $s_{i+2}$), la deuxième opération combinatoire ($\Phi_v$) donnant la valeur de la deuxième variable binaire ($x_{vi}$) associée au premier signal ($s_i$), en fonction de la valeur de chacune de la ou des premières variables binaires ($x_{ci+1}$, $x_{ci+2}$) associées respectivement au ou aux deuxièmes signaux ($s_{i+1}$, $s_{i+2}$) et en fonction de la valeur de chacune de la ou des deuxièmes variables binaires ($x_{vi+1}$, $x_{vi+2}$) associées respectivement au ou aux deuxièmes signaux ($s_{i+1}$, $s_{i+2}$).

3. Procédé selon la revendication 2, **caractérisé en ce que** la première règle (Rc) construit le premier diagramme de décision binaire ($T_c(s_i)$), associé au premier signal ($s_i$), en remplaçant dans la première opération combinatoire ($\Phi_c$) chacune des premières variables binaires ($x_{ci+1}$, $x_{ci+2}$) associées aux deuxièmes signaux ($s_{i+1}$, $s_{i+2}$) par chacun des premiers diagrammes de décision binaire ($T_c(s_{i+1})$, $T_c(s_{i+2})$) associés aux deuxièmes signaux ($s_{i+1}$, $s_{i+2}$) et chacune des deuxièmes variables binaires ($x_{vi+1}$, $x_{vi+2}$) associées aux deuxièmes signaux ($s_{i+1}$, $s_{i+2}$) par chacun des deuxièmes diagrammes de décision binaire ($T_v(s_{i+1})$, $T_v(s_{i+2})$) associés aux deuxièmes signaux ($s_{i+1}$, $s_{i+2}$).

4. Procédé selon la revendication 2 ou 3, **caractérisé en ce que** la deuxième règle (Rv) construit le deuxième diagramme de décision binaire ($T_v(s_i)$), associé au premier signal ($s_i$), en remplaçant dans la deuxième opération combinatoire ($\Phi_v$) chacune des premières variables binaires ($x_{ci+1}$, $x_{ci+2}$) associées aux deuxièmes signaux ($s_{i+1}$, $s_{i+2}$) par chacun des premiers diagrammes de décision binaire ($T_c(s_{i+1})$, $T_c(s_{i+2})$) associés aux deuxièmes signaux ($s_{i+1}$, $s_{i+2}$) et chacune des deuxièmes variables binaires ($x_{vi+1}$, $x_{vi+2}$) associées aux deuxièmes signaux ($s_{i+1}$, $s_{i+2}$) par chacun des deuxièmes diagrammes de décision binaire ($T_v(s_{i+1})$, $T_v(s_{i+2})$) associés aux deuxièmes signaux ($s_{i+1}$, $s_{i+2}$).

5. Procédé selon la revendication 1, **caractérisé en ce que**, le premier signal ($s_i$) ne dépendant d'aucun autre signal ($s_i$), la première règle (Rc) construit le premier diagramme de décision binaire ($T_c(s_i)$), associé au premier signal ($s_i$), en créant un triplet ({No,Pg,Pd}) comprenant un noeud (No) occupé par la première variable ($x_{ci}$), un pointeur gauche (Pg) sur la deuxième valeur (0) et un pointeur droit (Pd) sur la deuxième valeur (1).

6. Procédé selon la revendication 1 ou 5, **caractérisé en ce que**, le premier signal ($s_i$) ne dépendant d'aucun autre signal ($s_i$), la deuxième règle (Rv) construit le deuxième diagramme de décision binaire ($T_v(s_i)$), associé au premier signal ($s_i$), en créant un triplet ({No',Pg',Pd'}) comprenant un noeud (No') occupé par la première variable ($x_{vi}$), un pointeur gauche (Pg') sur la deuxième valeur (0) et un pointeur droit (Pd') sur la deuxième valeur (1).

7. Procédé selon l'une des revendications 1 à 6, **caractérisé en ce que** :

- la première étape associe au premier signal ($s_i$) un troisième diagramme de décision binaire ($T_e(s_i)$) ; et
- la deuxième étape construit le troisième diagramme de décision binaire ($T_e(s_i)$) au moyen d'une troisième règle (Re) faisant conduire le troisième diagramme de décision binaire ($T_e(s_i)$) à la première valeur (1) lorsque la première variable binaire ($x_{ci}$) n'est pas à sa première valeur (1) et lorsque la deuxième variable binaire ($x_{vi}$) n'est pas à sa première valeur (1).

8. Procédé selon la revendication 7, **caractérisé en ce que**, le premier signal ($s_i$) étant généré par une entité élémentaire recevant en entrée un ou plusieurs deuxièmes signaux ($s_{i+1}$, $s_{i+2}$) auxquels sont appliqués la première et la deuxième étape, une troisième opération combinatoire ($\Phi_e$) est associée à cette entité, la troisième opération combinatoire ($\Phi_e$) donnant une deuxième valeur de la première variable binaire ($x_{ci}$) et une deuxième valeur de la deuxième variable binaire ($x_{vi}$) associées au premier signal ($s_i$), en fonction de la valeur de chacune de la ou des premières variables binaires ($x_{ci+1}$, $x_{ci+2}$) associées respectivement au ou aux deuxièmes signaux ($s_{i+1}$, $s_{i+2}$)

et en fonction de la valeur de chacune de la ou des deuxièmes variables binaires ($x_{vi+1}$, $x_{vi+2}$) associées respectivement au ou aux deuxièmes signaux ($s_{i+1}$, $s_{i+2}$).

9. Procédé selon la revendication 8, **caractérisé en ce que** la troisième règle (Re) construit le troisième diagramme de décision binaire ($T_e(s_i)$), associé au premier signal ($s_i$), en remplaçant dans la troisième opération combinatoire ($\Phi_e$) chacune des premières variables binaires ($x_{ci+1}$, $x_{ci+2}$) associées aux deuxièmes signaux ($s_{i+1}$, $s_{i+2}$) par chacun des premiers diagrammes de décision binaire ($T_c(s_{i+1})$, $T_c(s_{i+2})$) associés aux deuxièmes signaux ($s_{i+1}$, $s_{i+2}$) et chacune des deuxièmes variables binaires ($x_{vi+1}$, $x_{vi+2}$) associées aux deuxièmes signaux ($s_{i+1}$, $s_{i+2}$) par chacun des deuxièmes diagrammes de décision binaire ($T_v(s_{i+1})$, $T_v(s_{i+2})$) associés aux deuxièmes signaux ($s_{i+1}$, $s_{i+2}$).

10. Système informatique incluant au moins un processeur et une mémoire, **caractérisé en ce que** la mémoire contient un programme pour la mise en oeuvre du procédé selon l'une des revendications 1 à 9.

11. Programme d'ordinateur comprenant des portions / moyens / Instructions de code de programme pour l'exécution du procédé selon l'une des revendications 1 à 9 lorsque ledit programme est exécuté sur un système informatique.

12. Support d'enregistrement de programme d'ordinateur, **caractérisé en ce qu'**il comprend un programme lisible par une machine d'un système informatique pour commander l'exécution du procédé selon l'une des revendications 1 à 9.

## Claims

1. Method for encoding more than two possible states (H, B, Z) of a first signal ($s_i$), **characterised in that** it comprises:

   - a first step that associates with the first signal ($s_i$) a first binary variable ($x_{ci}$), a first value (1) of which indicates that the first signal ($s_i$) is in a first state (H) or in a second state (B), a second binary variable ($x_{vi}$), a first value (1) of which indicates that the first signal ($s_i$) is in the first state (H) or in a third state (Z), a first binary decision diagram ($T_c(s_i)$), and a second binary decision diagram ($T_v(s_i)$); and

   - a second step that constructs the first binary decision diagram ($T_c(s_i)$) by means of a first rule (Rc) causing the first binary decision diagram ($T_c(s_i)$) to lead to a first value (1) when the first binary variable ($x_{ci}$) is at its first value (1), and that constructs the second binary decision diagram ($T_v(s_i)$) by means of a second rule (Rv) causing the second binary decision diagram ($T_v(s_i)$) to lead to the first value (1) when the second binary variable ($x_{vi}$) is at its first value (1).

2. Method according to Claim 1, **characterised in that**, the first signal ($s_i$) being generated by an elementary entity receiving as input one or more second signals ($s_{i+1}$, $s_{i+2}$) to which the first and second steps are applied, a first combinatorial operation ($\Phi_c$) and a second combinatorial operation ($\Phi_v$) are associated with this entity, the first combinatorial operation ($\Phi_c$) giving the value of the first binary variable ($x_{ci}$) associated with the first signal ($s_i$), as a function of the value of each of the first binary variable(s) ($x_{ci+1}$, $x_{ci+2}$) respectively associated with the second signal(s) ($s_{i+1}$, $s_{i+2}$), and as a function of the value of each of the second binary variable(s) ($x_{vi+1}$, $x_{vi+2}$) respectively associated with the second signal(s) ($s_{i+1}$, $s_{i+2}$), the second combinatorial operation ($\Phi_v$) giving the value of the second binary variable ($x_{vi}$) associated with the first signal ($s_i$), as a function of the value of each of the first binary variable(s) ($x_{ci+1}$, $x_{ci+2}$) respectively associated with the second signal(s) ($s_{i+1}$, $s_{i+2}$) and as a function of the value of each of the second binary variable(s) ($x_{vi+1}$, $x_{vi+2}$) respectively associated with the second signal(s) ($s_{i+1}$, $s_{i+2}$).

3. Method according to Claim 2, **characterised in that** the first rule (Rc) constructs the first binary decision diagram ($T_c(s_i)$), associated with the first signal ($s_i$), by replacing in the first combinatorial operation ($\Phi_c$) each of the first binary variables ($x_{ci+1}$, $x_{ci+2}$) associated with the second signals ($s_{i+1}$, $s_{i+2}$) by each of the first binary decision diagrams ($T_c(s_{i+1})$, $T_c(s_{i+2})$) associated with the second signals ($s_{i+1}$, $s_{i+2}$) and each of the second binary variables ($x_{vi+1}$, $x_{vi+2}$) associated with the second signals ($s_{i+1}$, $s_{i+2}$) by each of the second binary decision diagrams ($T_v(s_{i+1})$, $T_v(s_{i+2})$) associated with the second signals ($s_{i+1}$, $s_{i+2}$).

4. Method according to Claim 2 or 3, **characterised in that** the second rule (Rv) constructs the second binary decision diagram ($T_v(s_i)$), associated with the first signal ($s_i$), by replacing in the second combinatorial operation ($\Phi_v$) each of the first binary variables ($x_{ci+1}$, $x_{ci+2}$) associated with the second signals ($s_{i+1}$, $s_{i+2}$) by each of the first binary decision diagrams ($T_c(s_{i+1})$, $T_c(s_{i+2})$) associated with the second signals ($s_{i+1}$, $s_{i+2}$) and each of the second binary

variables ($x_{vi+1}$, $x_{vi+2}$) associated with the second signals ($s_{i+1}$, $s_{i+2}$) by each of the second binary decision diagrams ($T_v(s_{i+1})$, $T_v(s_{i+2})$) associated with the second signals ($s_{i+1}$, $s_{i+2}$).

5. Method according to Claim 1, **characterised in that**, the first signal ($s_i$) not depending on any other signal ($s_i$), the first rule (Rc) constructs the first binary decision diagram ($T_c(s_i)$), associated with the first signal ($s_i$), by creating a triplet ({No, Pg, Pd}) comprising a node (No) occupied by the first variable ($x_{ci}$), a left pointer (Pg) to the second value (0) and a right pointer (Pd) to the second value (1).

6. Method according to Claim 1 or 5, **characterised in that**, the first signal ($s_i$) not depending on any other signal ($s_i$), the second rule (Rv) constructs the second binary decision diagram ($T_v(s_i)$), associated with the first signal ($s_i$), by creating a triplet ({No', Pg', Pd'}) comprising a node (No') occupied by the first variable ($x_{vi}$), a left pointer (Pg') to the second value (0) and a right pointer (Pd') to the second value (1).

7. Method according to one of Claims 1 to 6, **characterised in that**:

    - the first step associates with the first signal (si) a third binary decision diagram (Te(si)); and

    - the second step constructs the third binary decision diagram ($T_e(s_i)$) by means of a third rule (Re) causing the third binary decision diagram ($T_e(s_i)$) to lead to the first value (1) when the first binary variable ($x_{ci}$) is not at its first value (1) and when the second binary variable ($x_{vi}$) is not at its first value (1).

8. Method according to Claim 7, **characterised in that**, the first signal ($s_i$) being generated by an elementary unit receiving as input one or more second signals ($s_{i+1}$, $s_{i+2}$) to which the first and second steps are applied, a third combinatorial operation ($\Phi_e$) is associated with this entity, the third combinatorial operation ($\Phi_e$) giving a second value of the first binary variable ($x_{ci}$) and a second value of the second binary variable ($x_{vi}$) associated with the first signal ($s_i$), as a function of the value of each of the first binary variable(s) ($x_{ci+1}$, $x_{ci+2}$) respectively associated with the second signal(s) ($s_{i+1}$, $s_{i+2}$) and as a function of the value of each of the second binary variable(s) ($x_{vi+1}$, $x_{vi+2}$) respectively associated with the second signal(s) ($s_{i+1}$, $s_{i+2}$).

9. Method according to Claim 8, **characterised in that** the third rule (Re) constructs the third binary decision diagram ($T_e(s_i)$), associated with the first signal ($s_i$), by replacing in the third combinatorial operation ($\Phi_e$) each of the first binary variables ($x_{ci+1}$, $x_{ci+2}$) associated with the second signals ($s_{i+1}$, $s_{i+2}$) by each of the first binary decision diagrams ($T_c(s_{i+1})$, $T_c(s_{i+2})$) associated with the second signals ($s_{i+1}$, $s_{i+2}$) and each of the second binary variables ($x_{vi+1}$, $x_{vi+2}$) associated with the second signals ($s_{i+1}$, $s_{i+2}$) by each of the second binary decision diagrams ($T_v(s_{i+1})$, $T_v(s_{i+2})$) associated with the second signals ($s_{i+1}$, $s_{i+2}$).

10. Computer system including at least one processor and one memory, **characterised in that** the memory contains a program for implementing the method according to one of Claims 1 to 9.

11. Computer program comprising program code portions/means/instructions for executing the method according to one of Claims 1 to 9 when said program is executed on a computer system.

12. Computer program recording medium, **characterised in that** it comprises a program readable by a machine of a computer system for controlling the execution of the method according to one of Claims 1 to 9.

**Patentansprüche**

1. Verfahren zum Codieren von mehr als zwei möglichen Zuständen (H, B, Z) eines ersten Signals ($s_i$), **dadurch gekennzeichnet, dass** es umfasst:

    - einen ersten Schritt, der dem ersten Signal ($s_i$) eine erste binäre Variable ($x_{ci}$), wovon ein erster Wert (1) angibt, dass das erste Signal ($s_i$) in einem ersten Zustand (H) oder in einem zweiten Zustand (B) ist, eine zweite binäre Variable ($x_{vi}$), wovon ein erster Wert (1) angibt, dass das erste Signal ($s_i$) in dem ersten Zustand (H) oder in einem dritten Zustand (Z) ist, ein erstes binäres Entscheidungsdiagramm ($T_c(s_i)$) und ein zweites binäres Entscheidungsdiagramm ($T_v(s_i)$) zuordnet; und

    - einen zweiten Schritt, der das erste binäre Entscheidungsdiagramm ($T_c(s_i)$) mittels einer ersten Regel (Rc) konstruiert, die das erste binäre Entscheidungsdiagramm ($T_c(s_i)$) zu einem ersten Wert (1) führt, wenn die erste binäre Variable ($x_{ci}$) ihren ersten Wert (1) hat, und der das zweite binäre Entscheidungsdiagramm ($T_v(s_i)$) mittels einer zweiten Regel (Rv) konstruiert, die das zweite binäre Entscheidungsdiagramm ($T_v(s_i)$) zu dem ersten Wert (1) führt, wenn die zweite binäre Variable ($x_{vi}$) ihren ersten Wert (1) hat.

2. Verfahren nach Anspruch 1, **dadurch gekennzeichnet, dass** dann, wenn das erste Signal ($s_i$) durch eine elementare Entität erzeugt wird, die am Eingang eines oder mehrere zweite Signale ($s_{i+1}$, $s_{i+2}$) empfängt, auf die der erste und der zweite Schritt angewendet werden, dieser Entität eine erste kombinatorische Operation ($\Phi_c$) und eine zweite kombinatorische Operation ($\Phi_v$) zugeordnet werden, wobei die erste kombinatorische Operation ($\Phi_c$) den Wert der ersten binären Variable ($x_{ci}$), die dem ersten Signal ($s_i$) zugeordnet ist, in Abhängigkeit vom Wert jeder der ersten binären Variablen ($x_{ci+1}$, $x_{ci+2}$), die dem bzw. den zweiten Signalen ($s_{i+1}$, $s_{i+2}$) zugeordnet sind, und in Abhängigkeit vom Wert jeder der zweiten binären Variablen ($x_{vi+1}$, $x_{vi+2}$), die dem bzw. den zweiten Signalen ($s_{i+1}$, $s_{i+2}$) zugeordnet sind, ergibt und wobei die zweite kombinatorische Operation ($\Phi_v$) den Wert der zweiten binären Variable ($x_{vi}$), die dem ersten Signal ($s_i$) zugeordnet ist, in Abhängigkeit vom Wert jeder der ersten binären Variablen ($x_{ci+1}$, $x_{ci+2}$), die dem bzw. den zweiten Signalen ($s_{i+1}$, $s_{i+2}$) zugeordnet sind, und in Abhängigkeit vom Wert jeder der zweiten binären Variablen ($x_{vi+1}$, $x_{vi+2}$), die dem bzw. den zweiten Signalen ($s_{i+1}$, $s_{i+2}$) zugeordnet sind, ergibt.

3. Verfahren nach Anspruch 2, **dadurch gekennzeichnet, dass** die erste Regel (Rc) das erste binäre Entscheidungsdiagramm ($T_c(s_i)$), das dem ersten Signal ($s_i$) zugeordnet ist, dadurch konstruiert, dass sie in der ersten kombinatorischen Operation ($\Phi_c$) jede der ersten binären Variablen ($x_{ci+1}$, $x_{ci+2}$), die den zweiten Signalen ($s_{i+1}$, $s_{i+2}$) zugeordnet sind, durch jedes der ersten binären Entscheidungsdiagramme ($T_c(s_{i+1})$, $T_c(s_{i+2})$), die den zweiten Signalen ($s_{i+1}$, $s_{i+2}$) zugeordnet sind, ersetzt und jede der zweiten binären Variablen ($x_{vi+1}$, $x_{vi+2}$), die den zweiten Signalen ($s_{i+1}$, $s_{i+2}$) zugeordnet sind, durch jedes der zweiten binären Entscheidungsdiagramme ($T_v(s_{i+1})$, $T_v(s_{i+2})$), die den zweiten Signalen ($s_{i+1}$, $s_{i+2}$) zugeordnet sind, ersetzt.

4. Verfahren nach Anspruch 2 oder 3, **dadurch gekennzeichnet, dass** die zweite Regel (Rv) das zweite binäre Entscheidungsdiagramm ($T_v(s_i)$), das dem ersten Signal ($s_i$) zugeordnet ist, dadurch konstruiert, dass es in der zweiten kombinatorischen Operation ($\Phi_v$) jede der ersten binären Variablen ($x_{ci+1}$, $x_{ci+2}$), die den zweiten Signalen ($s_{i+1}$, $s_{i+2}$) zugeordnet sind, durch jedes der ersten binären Entscheidungsdiagramme ($T_c(s_{i+1})$, $T_c(s_{i+2})$), die den zweiten Signalen ($s_{i+1}$, $s_{i+2}$) zugeordnet sind, ersetzt und jede der zweiten binären Variablen ($x_{vi+1}$, $x_{vi+2}$), die den zweiten Signalen ($s_{i+1}$, $s_{i+2}$) zugeordnet sind, durch jedes der zweiten binären Entscheidungsdiagramme ($T_v(s_{i+1})$, $T_v(s_{i+2})$), die den zweiten Signalen ($s_{i+1}$, $s_{i+2}$) zugeordnet sind, ersetzt.

5. Verfahren nach Anspruch 1, **dadurch gekennzeichnet, dass** die erste Regel (Rc) dann, wenn das erste Signal ($s_i$) von keinem anderen Signal ($s_i$) abhängt, das erste binäre Entscheidungsdiagramm ($T_c(s_i)$), das dem ersten Signal ($s_i$) zugeordnet ist, dadurch konstruiert, dass sie ein Triplett ({No, Pg, Pd}) erzeugt, das einen von der ersten Variable ($x_{ci}$) besetzten Knoten (No), einen linken Zeiger (Pg) auf den zweiten Wert (0) und einen rechten Zeiger (Pd) auf den zweiten Wert (1) umfasst.

6. Verfahren nach Anspruch 1 oder 5, **dadurch gekennzeichnet, dass** die zweite Regel (Rv) dann, wenn das erste Signal ($s_i$) von keinem anderen Signal ($s_i$) abhängt, das zweite binäre Entscheidungsdiagramm ($T_v(s_i)$), das dem ersten Signal ($s_i$) zugeordnet ist, dadurch konstruiert, dass es ein Triplett ({No', Pg', Pd'}) erzeugt, das einen von der ersten Variable ($x_{vi}$) besetzten Knoten (No'), einen linken Zeiger (Pg') auf den zweiten Wert (0) und einen rechten Zeiger (Pd') auf den zweiten Wert (1) umfasst.

7. Verfahren nach einem der Ansprüche 1 bis 6, **dadurch gekennzeichnet, dass**:

   - der erste Schritt dem ersten Signal ($s_i$) ein drittes binäres Entscheidungsdiagramm ($T_e(s_i)$) zuordnet; und

   - der zweite Schritt das dritte binäre Entscheidungsdiagramm ($T_e(s_i)$) mittels einer dritten Regel (Re) konstruiert, die das dritte binäre Entscheidungsdiagramm ($T_e(s_i)$) zu dem ersten Wert (1) führt, wenn die erste binäre Variable ($x_{ci}$) nicht ihren ersten Wert (1) hat und wenn die zweite binäre Variable ($x_{vi}$) nicht ihren ersten Wert (1) hat.

8. Verfahren nach Anspruch 7, **dadurch gekennzeichnet, dass** dann, wenn das erste Signal ($s_i$) durch eine elementare Entität erzeugt wird, die am Eingang eines oder mehrere zweite Signale ($s_{i+1}$, $s_{i+2}$) empfängt, auf die der erste und der zweite Schritt angewendet werden, dieser Entität eine dritte kombinatorische Operation ($\Phi_e$) zuge-

ordnet wird, wobei die dritte kombinatorische Operation ($\Phi_e$) einen zweiten Wert der ersten binären Variable ($x_{ci}$) und einen zweiten Wert der zweiten binären Variable ($x_{vi}$), die dem ersten Signal ($s_i$) zugeordnet sind, in Abhängigkeit vom Wert jeder der ersten binären Variablen ($x_{ci+1}$, $x_{ci+2}$), die dem bzw. den zweiten Signalen ($s_{i+1}$, $s_{i+2}$) zugeordnet sind, und in Abhängigkeit vom Wert jeder der zweiten binären Variablen ($x_{vi+1}$, $x_{vi+2}$), die dem bzw. den zweiten Signalen ($s_{i+1}$, $s_{i+2}$) zugeordnet sind, ergibt.

9. Verfahren nach Anspruch 8, **dadurch gekennzeichnet, dass** die dritte Regel (Re) das dritte binäre Entscheidungsdiagramm ($T_e(s_i)$), das dem ersten Signal ($s_i$) zugeordnet ist, dadurch konstruiert, dass sie in der dritten kombinatorischen Operation ($\Phi_e$) jede der ersten binären Variablen ($x_{ci+1}$, $x_{ci+2}$), die den zweiten Signalen ($s_{i+1}$, $s_{i+2}$) zugeordnet sind, durch jedes der ersten binären Entscheidungsdiagramme ($T_c(s_{i+1})$, $T_c(s_{i+2})$), die den zweiten Signalen ($s_{i+1}$, $s_{i+2}$) zugeordnet sind, ersetzt und jede der zweiten binären Variablen ($x_{vi+1}$, $x_{vi+2}$), die den zweiten Signalen ($s_{i+1}$, $s_{i+2}$) zugeordnet sind, durch jedes der zweiten binären Entscheidungsdiagramme ($T_v(s_{i+1})$, $T_v(s_{i+2})$), die den zweiten Signalen ($s_{i+1}$, $s_{i+2}$) zugeordnet sind, ersetzt.

10. Datenverarbeitungssystem, das wenigstens einen Prozessor und einen Speicher enthält, **dadurch gekennzeichnet, dass** der Speicher ein Programm für die Ausführung des Verfahrens nach einem der Ansprüche 1 bis 9 enthält.

11. Rechnerprogramm, das Programmcode-Teile/-Mittel/-Befehle, die das Verfahren nach einem der Ansprüche 1 bis 9 ausführen, wenn das Programm auf einem Datenverarbeitungssystem ausgeführt wird, umfasst.

12. Aufzeichnungsträger für Rechnerprogramm, **dadurch gekennzeichnet, dass** er ein Programm enthält, das von einer Maschine eines Datenverarbeitungssystems lesbar ist, um die Ausführung des Verfahrens nach einem der Ansprüche 1 bis 9 zu steuern.

**Fig.1**

$$S_i$$

$$(x_{vi}, x_{ci}) \rightarrow S_i \qquad 1$$

$$T_c(S_i) \rightarrow S_i$$
$$T_v(S_i) \rightarrow S_i$$
$$T_e(S_i) \rightarrow S_i \qquad 2$$

non

$$x_{ci} = ? \Phi_c(x_{ci+1}, x_{vi+1}, \dots)$$
$$x_{vi} = ? \Phi_v(x_{ci+1}, x_{vi+1}, \dots)$$
$$(x_{vi}, x_{ci}) = ?$$
$$\Phi_e(x_{ci+1}, x_{vi+1}, \dots)$$

3

oui

$$S_{i+1}, \dots \qquad 4$$

$$T_c(S_i) = \Phi_c(T_c(S_{i+1}), T_v(S_{i+1}), \dots)$$
$$T_v(S_i) = \Phi_v(T_c(S_{i+1}), T_v(S_{i+1}), \dots)$$
$$T_e(S_i) = \Phi_e(T_c(S_{i+1}), T_v(S_{i+1}), T_e(S_{i+1}), \dots) \qquad 5$$

Retour

6

**Fig.2**

**Fig.3**

**Fig.4**

**Fig.5**